(19) Europäisches Patentamt
European Patent Office
Office européen des brevets

(11) **EP 0 779 723 B1**

(12) **EUROPÄISCHE PATENTSCHRIFT**

(45) Veröffentlichungstag und Bekanntmachung des Hinweises auf die Patenterteilung:
**07.05.2008 Patentblatt 2008/19**

(51) Int Cl.:
*H04L 7/033* (2006.01)   *G11B 20/14* (2006.01)
*H03L 7/085* (2006.01)

(21) Anmeldenummer: **96119413.1**

(22) Anmeldetag: **04.12.1996**

(54) **Digitale Detektorschaltung zur Rückgewinnung des Bittaktes mit Phasen- und Pulslängendetektor**

Digital clock recovery circuit with phase detection and pulse width detection

Système de récupération d'horloge avec un détecteur de phase et un détecteur de largeur d'impulsion

(84) Benannte Vertragsstaaten:
**DE FR GB IT**

(30) Priorität: **14.12.1995 DE 19546632**

(43) Veröffentlichungstag der Anmeldung:
**18.06.1997 Patentblatt 1997/25**

(73) Patentinhaber: **THOMSON Licensing**
**92100 Boulogne-Billancourt (FR)**

(72) Erfinder:
• **Rominger, Friedrich**
**Indianapolis,**
**Indiana 46206-6139 (US)**
• **Schemmann, Heinrich**
**78052 Villingen-Schwenningen (DE)**
• **Rothermel, Albrecht**
**89231 Neu-Ulm (DE)**

(56) Entgegenhaltungen:
**EP-A- 0 544 358       DE-A- 3 615 952**
**US-A- 4 495 474**

**Beschreibung**

Die Erfindung betrifft eine digitale Detektorschaltung zur Rückgewinnung des Bittaktes aus einem Datenstrom, wobei vorzugsweise ein EFM-Datenstrom betrachtet wird, der bei der Wiedergabe einer CD-Platte gelesen wird. Die digitale Detektorschaltung ist dabei Bestandteil eines Phasenregelkreises (PLL). Die Erfindung betrifft weiterhin ein Verfahren zur Bildung eines Nachstimmwertes für die Oszillatorfrequenz eines Phasenregelkreises PLL.

In bekannten Systemen zur Rückgewinnung des Bittaktes eines Datenstroms, wie er beispielsweise in Datendecodierern für optische Platten, beispielsweise CDs, verwendet wird, muß der Takt des Phasenregelkreises auf das ankommende Datensignal phasenrichtig einrasten oder synchronisieren, so daß die Bitinformation des Datenstroms decodiert werden kann. So erfolgt bei bekannten Systemen, beispielsweise bei einem CD-Spieler, die Grobabstimmung bis zum ersten Einrasten der PLL durch die Regelung des Plattenmotors. Dieser Vorgang ist aufgrund der mechanischen Trägheit des Motors relativ langsam und störanfällig. Weiterhin hat in konventionellen Lösungen der Phasenregelkreis nur einen kleinen Fangbereich.

Der Erfindung liegt daher die Aufgabe zugrunde, einen Bittaktdetektor und ein entsprechendes Verfahren zu realisieren, der eine PLL mit verbessertem Fangverhalten ermöglicht.

Die Aufgabe wird durch die Merkmale der unabhängigen Ansprüche 1 und 10 gelöst. Bevorzugte Ausgestaltungen der Erfindung sind Gegenstand der Unteransprüche.

Die erfindungsgemäße digitale Detektorschaltung zur Rückgewinnung des Bittaktes eines Datenstrom, wobei die Detektorschaltung Bestandteil eines Phasenregelkreises ist, weist einen digitalen Phasendetektor und einen digitalen Pulslängendetektor auf, deren Ausgangssignale addiert und integriert werden, so daß das Ergebnis als Nachstimmwert für die Oszillatorfrequenz der PLL verwendet werden kann.
Vorzugsweise wird der digitale Phasendetektor der erfindungsgemäßen Detektorschaltung durch ein digitales Filter gebildet. Der digitale Phasendetektor bestimmt den Phasenwert P in Bruchteilen der Taktperiode des PLL-Oszillators, wobei der Phasenwert definiert ist als die Phasendifferenz des nächstgelegenen Oszillatortaktpulses der PLL zu einem Puls des Datenstroms. Die Pulslänge L eines Signals des Datenstroms wird in ganzen Zahlen und Bruchteilen der Taktperiode der Oszillatorfrequenz der PLL bestimmt.

Die Pulslänge L, die in Anzahlen der Taktperiode des PLL-Oszillators ausgedrückt wird, liegt zwischen 0 und einem maximalen Wert Max, der von der gewünschten Auflösung und der Oszillatorfrequenz abhängt und die Darstellung der Pulslänge als digitale Zahl bestimmen wird.

Zur allgemeinen Definition des verwendeten Algorithmus werden noch die Zahlen Max1, Max2, Min1, Min2 benötigt, wobei die folgende Ungleichung gilt:

$$\mathtt{Max > Max1 > Max2 > ... > Min2 > Min1 > 0}$$

Dabei sind die obigen Zahlen im allgemeinen rationale Zahlen.

Der Pulslängendetektor, der ein wesentliches Element der Detektorschaltung ist, weist ein Steuerwerk auf, durch das in Abhängigkeit von einer vorgegebenen Funktion der Pulslängendetektor als Funktion einer vorgegebenen Funktion eines der folgenden drei Signale ausgibt:

a) Ausgegeben wird die Differenz zur nächsten ganzen Zahl des Intervalls [0,..., Max];
b) Ausgegeben wird die Differenz zur nächsten ganzen Zahl eines eingeschränkten Intervalls [Max2,...,Min2], wobei

b1) entweder alle positiven Glieder der detektierten Pulslängen oder
b2) alle negativen Glieder der detektierten Pulslängen auf 0 gesetzt werden.

Weiterhin besteht die vorgegebene Funktion, die die Entscheidung des Steuerwerks steuert, aus vier Vergleichen, nämlich ob für die momentan bestimmte Pulslänge L gilt:

c1) $L \geq Max1$
c2) $L \geq Max2$
c3) $L < Min2$ oder
c4) $L < Min1$ ist, wobei

die Entscheidung b1) gewählt wird, wenn die Pulslänge L in einer vorgegebenen endlichen Zeit je einmal für einen positiven und einen negativen Puls die Bedingung c1) erfüllt,

die Entscheidung b2) gewählt wird, wenn die Pulslänge L in einer vorgegebenen endlichen Zeit je einmal für einen positiven und einen negativen Puls die Bedingung c4) erfüllt.

Im Falle des Eintretens von c1) wird dieser Zustand wieder rückgängig gemacht, d.h. Ausgabe a) gewählt, wenn eine Entscheidung c3) detektiert wird (während des Zustands c1). Umgekehrt wird c4) rückgängig gemacht, d.h. Ausgabe a) gewählt, wenn während des Zustands c4) einmal das Eintreten von c2) detektiert wurde.

Vorteilhafte Maßnahmen gemäß den Unteransprüchen:

Vorzugsweise wird die Pulslänge L als 8 Bit Festkommazahl realisiert. Dabei sind 4 Bits für den ganzzahligen Teil der Pulslänge und 4 Bits für die 16-tel der Pulslänge, wobei die Pulslänge wie bereits erwähnt, in Einheiten der Oszillatortaktperiode bestimmt wird. Je nach Anwendung sind auch andere Grenzen wählbar, beispielsweise können 16 Bit verwendet werden, wobei z.B. 8 Bits für den ganzzahligen und 8 LSB-Bits für die Bruchteile genommen werden.

Vorzugsweise werden im Falle der obigen 8 Bit die folgenden Werte gewählt:

Max = 15 15/16
Max1 = 11,5
Max2 = 11
Min2 = 3
Min1 = 2,5

Anschaulich bedeutet der Fall der Signalausgabe a) eine relativ langsamere Regelung der Oszillatorfrequenz in beiden Richtungen (schneller, langsamer), während im Falle der Signalausgabe b), d.h. der beiden Unterfälle b1) und b2) das Nachstimmsignal größere Werte annimmt und daher die Oszillatorfrequenz in eine Richtung (entweder schneller oder langsamer) schnell geregelt wird, bis sich die Pulslänge wieder in einem mittleren Bereich befindet.

Ferner wird der Ausgang des Pulslängendetektors auf 0 gesetzt, wenn entweder ein Defekt detektiert wurde oder wenn die gesamte PLL synchronisiert ist.

Weiterhin wird in dem Fall, in dem die Differenz zur nächsten ganzen Zahl zwischen 3 und 11 ausgegeben wird, das Ausgangssignal mit einem Verstärkungsfaktor multipliziert.

Der Pulslängendetektor ist steuerbar, beispielsweise von einer Steuereinheit mit einem $\mu$-Prozessor oder $\mu$-Kontroller.

Nach der Addition des Phasenwertes und des Ausgangs des Pulslängendetektors kann das Ergebnis, wenn benötigt, mit einem Faktor -1 multipliziert werden.

Zusammenfassend ermöglicht die obige Schaltung die Realisierung einer Bittakt-PLL mit verbessertem Fangverhalten. Die PLL rastet auch bei anfangs stark verstimmter Oszillatorfrequenz schnell ein und hat danach eine geringe Anfälligkeit für Störungen im Signal. Somit sind kurze Zugriffszeiten möglich, was besonders bei Shockproof-Systemen und optischen Platten für Datenanwendungen von Bedeutung ist. Bedingt durch den großen Fangbereich der erfindungsgemäßen PLL ist auch das Lesen einer CLV-Platte mit CAV möglich. Als Anwendungen kommen primär eine Anwendung in Decodern für CDs mit EFM-Code in Betracht. Aber auch Anwendungen in optischen Medien für digitale Videoaufzeichnungen und Daten, sowie Decoder für andere RLL-Codes (Codes mit nach oben und unten beschränkter Lauflänge) sind denkbar.

Aus dem Patent US-A-4 495 474 ist eine Phasenregelkreissteuerung bekannt, die einen Referenzsignalgenerator aufweist, der ein Referenzsignal entsprechend des Phasenwertes eines digitalen Audio Signals erzeugt. Dieses Referenzsignal wird mit aufgezeichnet und wird bei Wiedergabe vom einem Phasenvergleicher und einem Detektor ausgewertet. Ein Addierer ist vorgesehen, der den Ausgangswert des Phasenvergleichers und den Ausgangswert des Detektors addiert und den Summenwert zur Nachstimmung des VCO Oszillators der PLL verwendet.

Ein Phasenregelkreis ist auch aus dem Dokument EP-A-0 544 358 bekannt. Dabei hat das HF Signal Abschnitte mit variabler Länge. Die Länge wird ausgewertet durch einen Pulslängenmesskreis. Darin wird die gemessene Länge in Richtung des nächst gelegenen Integer-Wertes gerundet. Der Rundungsfehler wird benutzt um Oszillatorfrequenz der PLL nachzustimmen.

Eine bevorzugte Ausführungsform der Erfindung ist nachfolgend in den Zeichnungen beschrieben, in denen:

Fig. 1    ein Prinzipschaltbild der erfindungsgemäßen Detektorschaltung zeigt,
Fig. 2    das Taktsignal der PLL sowie den Eingangsdatenstrom zeigt, und
Fig. 3    den erfindungsgemäßen Pulslängendetektor zeigt.

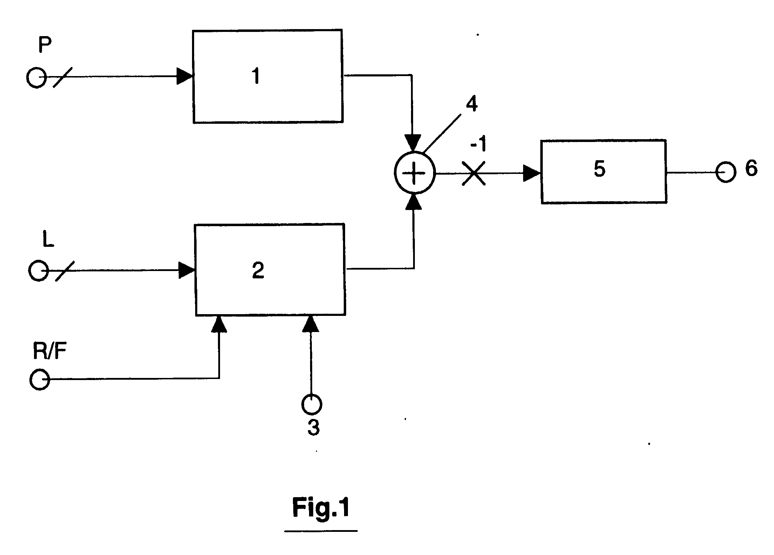

Fig. 1 zeigt die erfindungsgemäße Detektorschaltung, bestehend aus einem phasenverarbeitenden Teil mit einem Phasendetektor 1, der durch ein Digitalfilter realisiert ist, wobei die Phase P dem Phasendetektor 1 zugeführt wird, einem Pulslängendetektor 2, dem die Pulslänge L zugeführt wird. Zusätzlich zur Pulslänge L wird dem Pulslängendetektor 2 die Information, ob die Flanke steigend oder fallend war (R/F), zugeführt, sowie ein Steuersignal 3 von einer nicht dargestellten Steuereinheit. Die Ausgangssignale des Phasendetektors 1 und des Pulslängendetektors 2 werden in einem Addierer 4 addiert, das Ergebnis unter Umständen mit einem Faktor -1 multipliziert, und einem Integrator 5 zugeführt. Das so erhaltene Ausgangssignal 6 des Integrators 5 wird als ist der Nachstimmwert der Oszillatorfrequenz der PLL verwendet.

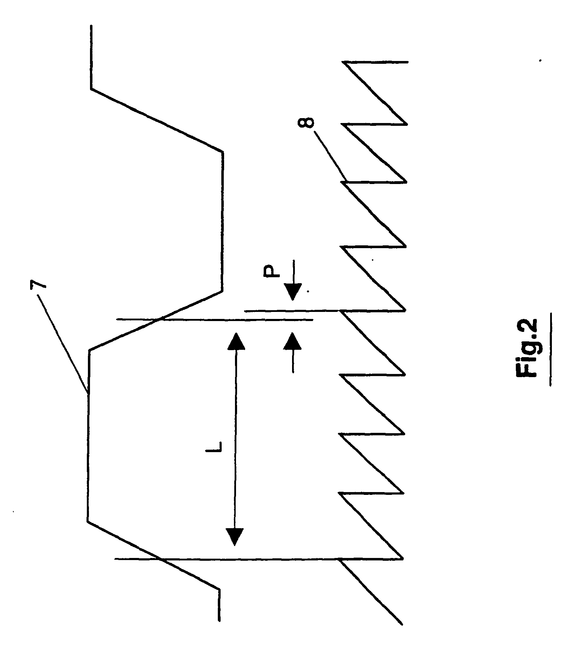

Fig. 2 zeigt vereinfacht die vorliegenden Signale, nämlich im oberen Teil das EFM-Signal, wie es von der CD kommt, sowie im unteren Teil das Taktsignal des Oszillators, der auf das Signal synchronisiert werden muß. Ferner sind die Definition der Pulslänge L sowie die Phasenlage P jeder Flanke relativ zur VCO-Taktflanke dargestellt. Dabei wird der Abstand zwischen zwei Flanken, d.h. die Impulslänge L, auf ganze und Bruchteile einer Taktperiode des PLL-Oszillators genau bestimmt. Die Phasenlage P wird in Bruchteilen der Taktperiode des PLL-Oszillators bestimmt.

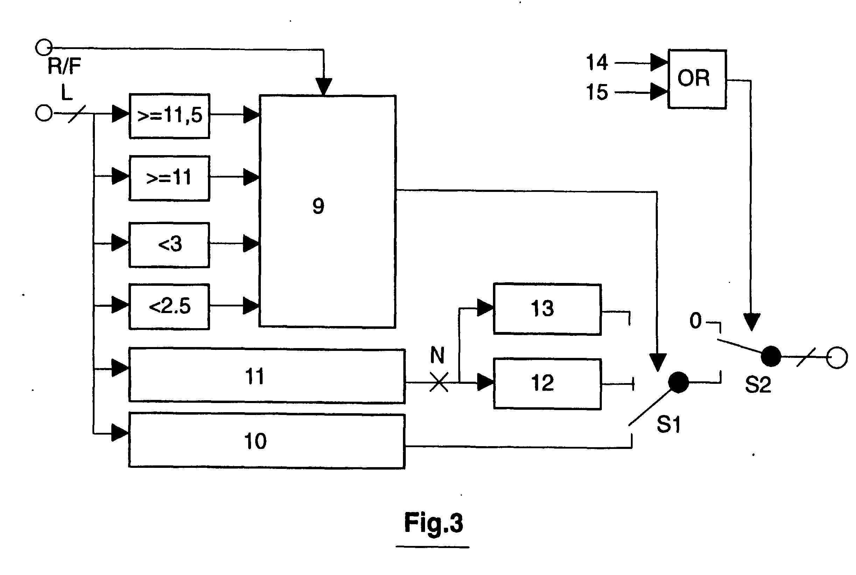

Fig. 3 zeigt das Prinzipschaltbild des Pulslängendetektors 2 der Fig. 1. Wie bereits erläutert, gibt L die Länge des letzten Impulses der EFM-Daten an. Vorzugsweise ist der Bereich L = [0; ... 15 15/16] realisiert. Der Wert L ist als 8 Bit-Festkommazahl realisiert, wobei 4 Bits für den ganzzahligen Teil (0 ... 15) und 4 Bits (LSB) dazu reserviert sind, um 16-tel einer Oszillatortaktperiode zu beschreiben. Andere Werte sind denkbar. Bei einer Wahl von einer 16-Bit-Auflösung mit 8 Bits für die ganze Zahl und 8 Bits für die Bruchteile ist der Wertebereich [0; ... 255 255/256]. Es werden vier einfache Vergleiche durchgeführt, deren Ergebnis ein Steuerwerk 9 beeinflussen, d.h. in Abhängigkeit von den Vergleichsergebnissen wird ein Schalter S1 geschaltet, der auswählt, welches Ausgangssignal der Pulslängendetektor generiert. Im Normalfall selektiert das Steuerwerk 9 die unterste Stellung des Schalters S1. In dieser Stellung wird in einer Recheneinheit 10 die Differenz der Impulslänge zur nächsten ganzen Zahl berechnet und ausgegeben. Beispiele sind in der folgenden Tabelle 1 aufgeführt, wobei die Tabelle auf den Wertebereich [0, ..., 15 15/16] basiert.

Tabelle 1

| | L | Ausgangswert |
|---|---|---|
| 3 | 4/16 | + 4/16 |
| 2 | 4/16 | + 4/16 |
| 15 | 4/16 | + 4/16 |
| 9 | 7/16 | + 7/16 |
| 4 | 8/16 | - 8/16 |
| 5 | 9/16 | - 7/16 |
| 7 | 15/16 | - 1/16 |

Ergeben die Vergleiche, daß die Pulslänge 11.5 überschritten wird, und zwar in endlicher Zeit je einmal für einen positiven und einen negativen Impuls (R-, F-Flanke), dann wird die mittlere Stellung des Schalters S1 gewählt. In diesem Zustand berechnet eine Recheneinheit 11 die Differenz zur nächsten ganzen Zahl, wobei der Bereich dieser ganzen Zahl auf 3...11 beschränkt ist. Beispiele dafür sind in der folgenden Tabelle 2 gegeben:

Tabelle 2

| | L | Ausgangswert |
|---|---|---|
| 3 | 4/16 | + 4/16 |
| 2 | 4/16 | - 12/16 ! |
| 15 | 4/16 | + 68/16 ! |
| 9 | 7/16 | + 7/16 |
| 4 | 8/16 | - 8/16 |
| 5 | 9/16 | - 7/16 |
| 7 | 15/16 | - 1/16 |

Zusätzlich werden durch eine Unterdrückungseinheit 12 alle negativen Differenzen auf 0 gesetzt, wenn der Schalter auf der mittleren Stellung steht.

Die obere Stellung des Schalters S1 wird dann gewählt, wenn der Vergleich ergibt, daß die Pulslänge kleiner als 2,5 ist, und zwar in endlicher Zeit je einmal für einen positiven und einen negativen Impuls. In diesem Falle wird von der Recheneinheit 1 ebenfalls die Differenz der Pulslänge zur nächsten ganzen Zahl berechnet, wobei die ganze Zahl wiederum auf den Bereich 3 bis 11 beschränkt ist, allerdings werden nun durch eine weitere Unterdrückungseinheit 13 sämtliche positiven Abweichungen der Recheneinheit 1 auf 0 gesetzt.

Zusätzlich wird in den beiden oberen Stellungen des Schalters S1 das Rechenergebnis vor dem Eintreten in die entsprechende Unterdrückungseinheit 12, 13 mit einem Verstärkungsfaktor n multipliziert. Mit anderen Worten, in der mittleren Stellung des Schalters S1 werden nur die positiven Impulslängenabweichungen gesehen, während in der oberen Stellung von S1 die negativen Pulslängenabweichungen erkannt werden. Da sich, wie sich aus der Tabelle 2 ergibt, für kleine und große Abweichungen große Ausgangswerte als Impulslängendetektor ergeben, wird bei derartigen Abweichungen zusammen mit dem Verstärkungsfaktor n vom Impulslängendetektor ein großes Ausgangssignal zum Steuern der Oszillatorfrequenz erzeugt. Mit anderen Worten, es soll bei derartigen Abweichungen eine große Änderung der Oszillatorfrequenz erzeugt werden, um die Steuerung wieder in den normalen Bereich (untere Schalterstellung) zurückzubringen. Die beiden oberen Schalterstellungen des Schalters S1 werden rückgängig gemacht, wenn bei langen Impulsen einmal ein Impuls gefunden wird, der die Länge < 3 aufweist bzw. bei kurzen Pulsregelungen eine Länge $\geq$ 11 aufweist. In einem solchen Falle wird die "beschleunigte" Regelungsstellung des Schalters S1 (oben bzw. mittig) verlassen, und der Schalter wird wieder in die unterste Stellung gesetzt.

Anschaulich bedeutet dies, wenn der Oszillator eine zu hohe Frequenz hat, daß das EFM-Impulssignal proportional zu lang erscheint, da dessen Länge in Periodendauern des Oszillatorsignals beschrieben wird. Demzufolge wird schnell heruntergeregelt. Ähnlich ist der Zustand, wenn die Platte sich relativ langsam dreht. Dann ist das Signal der Platte zeitlich gedehnt, so daß die Impulse ebenfalls lang aussehen. In beiden Fällen soll die Oszillatorfrequenz heruntergefahren werden, damit ein aufgezeichneter n x T langer Impuls der Platte auch n Oszillatortaktperioden lang ist.

Ist die PLL eingerastet, d.h. der Oszillatortakt ist synchron mit den EFM-Impulsen, wird dies durch das Signal 14 angezeigt. Dann wird das Ausgangssignal des Impulslängendetektors 1 durch einen zweiten Schalter S2 auf 0 gesetzt, d.h. eine Regelung findet nicht statt. Dieser Fall kann auch eintreten, wenn das Defektsignal 15 gesetzt ist.

Die Regelung ist nicht auf die gewählten Größen begrenzt, andere Darstellungen der Impulslänge L beispielsweise mit mehr Bit sind denkbar, so daß in diesem Fall die Zahlenbereiche modifiziert werden müssen.

**Patentansprüche**

1. Digitale Detektorschaltung eines Phasenregelkreises PLL zur Rückgewinnung des Bittaktes eines Datenstroms mit einer Detektorschaltung, die einen digitalen Phasendetektor (1) und einen digitalen Pulslängendetektor (2) aufweist, mit einem Addier- und Integrierwerk (5, 6), das die Ausgangssignale des Phasendetektors (1) und des Pulslängendetektors (2) addiert und integriert, zur Bildung eines Nachstimmwertes für die Oszillatorfrequenz des PLL-Oszillators, wobei der Phasenwert (P) in Bruchteilen der Taktperiode des PLL-Oszillators bestimmt wird und die Pulslänge L eines Signals des Datenstroms in Einheiten der Taktperiode der Oszillatorfrequenz der PLL bestimmt wird, wobei die Pulslänge aus dem Intervall [0,..., Max] ist, wobei der Pulslängendetektor (2) ein Steuerwerk (9) aufweist, **dadurch gekennzeichnet, daß** in Abhängigkeit von einer vorgegebenen Funktion F(L) der Pulslängendetektor (2) eines der folgenden Signale ausgibt:

   a) die Differenz zur nächsten ganzen Zahl des Intervalls [0,..., Max] wobei die Ausgabe a) die Voreinstellung bildet;
   b) die Differenz zur nächsten ganzen Zahl des eingeschränkten Intervalls [Min2,..., Max2], wobei [0 < Min1 < Min2 < ... < Max2 < Max1 < Max] gilt;
   wird falls L < Min1
   wird falls L > Max1,
   wobei in Abhängigkeit von der vorgegebenen Funktion F(L) im Fall der Ausgabe b) zusätzlich für die in b) bestimmte Differenz entweder

      b1) jede positive Differenz auf Null gesetzt wird, falls L < Min1, oder
      b2) jede negative Differenz auf Null gesetzt wobei [0 < Min1 < Min2 < ... < Max2 < Max1 < Max] gilt;
      wird falls L < Min1
      wird falls L > Max1;

   und die vorbestimmte Funktion F(L) vier Vergleiche durchführt, nämlich ob für die gegenwärtige Pulslänge L gilt:

      c1) L $\geq$ Max1
      c2) L $\geq$ Max2
      c3) L < Min2
      c4) L < Min1, und

   die Entscheidung b1) gewählt wird, wenn die Pulslänge L in einer vorgegebenen endlichen Zeit die Bedingung c1) erfüllt, und

die Entscheidung b2) gewählt wird, wenn die Pulslänge L in einer vorgegebenen endlichen Zeit die Bedingung c4) erfüllt; und

im eingetretenen Zustand b1) wieder die Entscheidung a) gewählt wird, wenn für die Pulslänge einmal c3) detektiert wird, und
im eingetretenen Zustand b2) wieder die Entscheidung a) gewählt wird, wenn für die Pulslänge einmal c2) detektiert wird.

2. Digitale Detektorschaltung nach Anspruch 1, **dadurch gekennzeichnet, daß** die Bedingung c1) oder c2) je einmal für einen positiven und einen negativen Puls der Pulslänge L in einer vorgegebenen endlichen Zeit erfüllt sein muß.

3. Detektorschaltung nach Anspruch 1 oder 2, **dadurch gekennzeichnet, daß** die Pulslänge (L) als 8 Bit Festkommazahl realisiert ist.

4. Detektorschaltung nach Anspruch 3, **dadurch gekennzeichnet, daß** 4 Bits der Pulslänge L für den ganzzahligen Teil und 4 Bits der Pulslänge für den sechzehnten Bruchteil einer Oszillatortaktperiode bestimmt sind.

5. Detektorschaltung nach Anspruch 4, **dadurch gekennzeichnet, daß** folgende Werte verwendet werden:

Max = 15 15/16
Max1 = 11,5
Max2 = 11
Min2 = 3
Min1 = 2,5.

6. Detektorschaltung nach einem der vorangegangenen Ansprüche, **dadurch gekennzeichnet, daß** der Ausgang des Pulslängendetektors (2) auf 0 gesetzt wird, wenn entweder ein Defekt detektiert wurde oder wenn die gesamte PLL synchronisiert ist.

7. Detektorschaltung nach Anspruch 6, **dadurch gekennzeichnet, daß** in dem Fall, daß die Differenz zur nächsten ganzen Zahl zwischen 3 und 11 ausgegeben wird, das Ausgangssignal mit einem Verstärkungsfaktor (n) multipliziert wird.

8. Detektorschaltung nach einem der vorangegangenen Ansprüche, **dadurch gekennzeichnet, daß** der Pulslängendetektor (2) steuerbar ist.

9. Detektorschaltung nach einem der vorangegangenen Ansprüche, **dadurch gekennzeichnet, daß** nach der Addition des Phasenwertes (P) und des Ausgangs des Pulslängendetektors (2) dieses Ergebniss mit einem Faktor -1 multipliziert werden.

10. Verfahren zur Bildung eines Nachstimmwertes für die Oszillatorfrequenz eines Phasenregelkreises PLL, welcher zur Rückgewinnung des Bittaktes eines Datenstroms verwendet wird, mit den Verfahrensschritten:

Bestimmen eines Phasenwertes (P) eines Signals des Datenstroms in Bruchteilen der Taktperiode des PLL-Oszillators;
Bestimmen der Pulslänge L eines Signals des Datenstroms in Einheiten der Taktperiode der Oszillatorfrequenz der PLL, wobei die Pulslänge aus dem Intervall [0,..., Max] ist, **dadurch gekennzeichnet, daß** bei der Pulslängenbestimmung in Abhängigkeit von einer vorgegebenen Funktion F(L) eines der folgenden Signale ausgegeben wird:

a) die Differenz zur nächsten ganzen Zahl des Intervalls [0,..., Max] wobei die Ausgabe a) die Voreinstellung bildet;
b) die Differenz zur nächsten ganzen Zahl des eingeschränkten Intervalls [Min2,..., Max2] wobei [0 < Min1 < Min2 < ... < Max2 < Max1 < Max] gilt; wobei in Abhängigkeit von der vorgegebenen Funktion F(L) im Fall der Ausgabe b) zusätzlich für die in b) bestimmte Differenz entweder

b1) jede positive Differenz auf Null gesetzt wird, falls L < Min1, oder
b2) jede negative Differenz auf Null gesetzt wird, falls L > Max1,

und die vorbestimmte Funktion F(L) vier Vergleiche durchführt, nämlich ob für die gegenwärtige Pulslänge L gilt:

c1) $L \geq Max1$
c2) $L \geq Max2$
c3) $L < Min2$
c4) $L < Min1$, und

die Entscheidung b1) gewählt wird, wenn die Pulslänge L in einer vorgegebenen endlichen Zeit die Bedingung c1) erfüllt, und
die Entscheidung b2) gewählt wird, wenn die Pulslänge L in einer vorgegebenen endlichen Zeit die Bedingung c4) erfüllt; und

im eingetretenen Zustand b1) wieder die Entscheidung a) gewählt wird, wenn für die Pulslänge einmal c3) detektiert wird, und
im eingetretenen Zustand b2) wieder die Entscheidung a) gewählt wird, wenn für die Pulslänge einmal c2) detektiert wird;

Addieren des Phasenwertes und des Pulslängenwertes sowie Integrieren der Summenwerte des vorhergehenden Schrittes zur Bildung des Nachstimmwertes für den Phasenregelkreis.

## Claims

1. Digital detector circuit of a phase-locked loop PLL for recovering the bit timing of a data stream, having a detector circuit which has a digital phase detector (1) and a digital pulse length detector (2), having an addition and integration mechanism (5, 6) which adds and integrates the output signals of the phase detector (1) and of the pulse length detector (2) in order to form a retuning value for the oscillator frequency of the PLL oscillator, the phase value (P) being determined in fractions of the clock period of the PLL oscillator and the pulse length L of a signal of the data stream being determined in units of the clock period of the oscillator frequency of the PLL, the pulse length being from the interval [0, ..., Max], the pulse length detector (2) having a control mechanism (9), **characterized in that**, depending on a predetermined function F(L), the pulse length detector (2) outputs one of the following signals:

   a) the difference from the nearest whole number of the interval [0, ..., Max], the output a) forming the presetting;
   b) the difference from the nearest whole number of the restricted interval [Max2,..., Min2], where [0 < Min1 < Min2 < ... < Max2 < Max1 < Max], wherein, depending on the predetermined function F(L), in the case of the output b), in addition, for the difference determined in b), either

   b1) each positive difference is set to zero if $L < Min1$, or
   b2) each negative difference is set to zero if $L > Max1$, and

   the predetermined function F(L) carries out four comparisons, namely whether the following is true for the present pulse length L:

   c1) $L \geq Max1$
   c2) $L \geq Max2$
   c3) $L < Min2$
   c4) $L < Min1$, and

   the decision b1) is selected when the pulse length L satisfies the condition c1) during a predetermined finite time, and
   the decision b2) is selected when the pulse length L satisfies the condition c4) during a predetermined finite time; and

   in the event that the state b1) has occurred, the decision a) is selected again the first time c3) is detected for the pulse length, and
   in the event that the state b2) has occurred, the decision a) is selected again the first time c2) is detected for the pulse length.

2. Detector circuit according to Claim 1, **characterized in that** the condition c1) or c2) must be satisfied in each case once for a positive and a negative pulse of the pulse length L during a predetermined finite time.

3. Detector circuit according to Claim 1 or 2, **characterized in that** the pulse length (L) is realized as an 8-bit fixed point number.

4. Detector circuit according to Claim 3, **characterized in that** 4 bits of the pulse length L are determined for the whole number part and 4 bits of the pulse length are determined for the sixteenth fraction of an oscillator clock period.

5. Detector circuit according to Claim 4, **characterized in that** the following values are used:

   Max = 15 15/16
   Max1 = 11.5
   Max2 = 11
   Min2 = 3
   Min1 = 2.5

6. Detector circuit according to one of the preceding claims, **characterized in that** the output of the pulse length detector (2) is set to 0 either when a defect has been detected or when the entire PLL is synchronized.

7. Detector circuit according to Claim 6, **characterized in that** the output signal is multiplied by an amplification factor (n) in the event that the difference from the next whole number between 3 and 11 is output.

8. Detector circuit according to one of the preceding claims, **characterized in that** the pulse length detector (2) is controllable.

9. Detector circuit according to one of the preceding claims, **characterized in that** after the addition of the phase value (P) and the output of the pulse length detector (2), this result is multiplied by a factor of -1.

10. Method for forming a retuning value for the oscillator frequency of a phase-locked loop PLL which is used for recovering the bit timing of a data stream, comprising the following method steps:

    determining a phase value (P) of a signal of the data stream in fractions of the clock period of the PLL oscillator; determining the pulse length L of a signal of the data stream in units of the clock period of the oscillator frequency of the PLL, the pulse length being from the interval [0, ..., Max], **characterized in that**, when determining the pulse length, depending on a predetermined function F(L), one of the following signals is output:

    a) the difference from the nearest whole number of the interval [0, ..., Max], the output a) forming the presetting;
    b) the difference from the nearest whole number of the restricted interval [Min2,...,Max2], where [0 < Min1 < Min2 < ... < Max2 < Max1 < Max], wherein, depending on the predetermined function F(L), in the case of the output b), in addition, for the difference determined in b), either

    b1) each positive difference is set to zero if L < Min1, or
    b2) each negative difference is set to zero if L > Max1, and

    the predetermined function F(L) carries out four comparisons, namely whether the following is true for the present pulse length L:

    c1) $L \geq$ Max1
    c2) $L \geq$ Max2
    c3) L < Min2
    c4) L < Min1, and

    the decision b1) is selected when the pulse length L satisfies the condition c1) during a predetermined finite time, and the decision b2) is selected when the pulse length L satisfies the condition c4) during a predetermined finite time; and

    in the event that the state b1) has occurred, the decision a) is selected again the first time c3) is detected for the pulse length, and

in the event that the state b2) has occurred, the decision a) is selected again the first time c2) is detected for the pulse length;

adding the phase value and the pulse length value, and integrating the summation values of the preceding step in order to form the retuning value for the phase-locked loop.

**Revendications**

1. Circuit de détection numérique d'une boucle à verrouillage de phase PLL pour la récupération d'horloge d'un flux de données avec un circuit de détection possédant un détecteur de phase numérique (1) et un détecteur de largeur d'impulsion numérique (2), avec un moyen d'addition et d'intégration, où [0 < Min1 < Min2 < ... < Max2 < Max1 < Max] s'applique, qui ajoute et intègre les signaux de sortie du détecteur de phase (1) et du détecteur de largeur d'impulsion (2), pour la génération d'une valeur de resyntonisation pour la fréquence d'oscillation de l'oscillateur de la PLL, où la valeur de phase (P) est définie en fractions de la période d'horloge de l'oscillateur de la PLL et la largeur d'impulsion L d'un signal du flux de données est définie en unités de la période d'horloge de la fréquence d'oscillation de la PLL, où la largeur d'impulsion appartient à l'intervalle [0, ..., Max], où le détecteur de largeur d'impulsion (2) possède un moyen de commande (9), **caractérisé en ce qu'**en fonction d'une fonction prédéfinie F(L), le détecteur de largeur d'impulsion (2) émet l'un des signaux suivants :

   a) la différence par rapport au nombre entier suivant de l'intervalle [0, ..., Max], où l'émission a) constitue le réglage par défaut ;
   b) la différence par rapport au nombre entier suivant de l'intervalle réduit [Min2, .., Max2], où [0 < Min1 < Min2 < ... < Max 2 < Max1 < Max] s'applique, où l'émission a) constitue le réglage par défaut, où, en outre, en fonction de la fonction prédéfinie F(L) dans le cas de l'émission b), pour la différence définie dans b), soit

      b1) chaque différence positive est définie sur zéro si L < Min1, soit
      b2) chaque différence négative est définie sur zéro si L > Max1,

   et la fonction prédéfinie F(L) exécute quatre comparaisons, pour vérifier si la largeur d'impulsion L actuelle correspond à :

      c1) $L \geq Max1$
      c2) $L \geq Max2$
      c3) $L < Min2$
      c4) $L < Min1$, et

   la décision b1) est choisie lorsque la largeur d'impulsion L remplit la condition c1) à un moment final prédéfini, et la décision b2) est choisie lorsque la largeur d'impulsion L remplit la condition c4) à un moment final prédéfini ; et

   lors de l'apparition de l'état b1), la décision a) est de nouveau choisie lorsque c3) est détectée une fois pour la largeur d'impulsion, et
   lors de l'apparition de l'état b2), la décision a) est de nouveau choisie lorsque c2) est détectée une fois pour la largeur d'impulsion.

2. Circuit de détection numérique selon la revendication 1, **caractérisé en ce que** la condition c1) ou c2) doit être remplie une fois pour une impulsion positive et une impulsion négative de la largeur d'impulsion L à un moment final prédéfini.

3. Circuit de détection selon la revendication 1 ou 2, **caractérisé en ce que** la largeur d'impulsion (L) est réalisée en tant que nombre à virgule fixe de 8 bits.

4. Circuit de détection selon la revendication 3, **caractérisé en ce que** 4 bits de la largeur d'impulsion L sont déterminés pour la partie à nombres entiers et 4 bits de la largeur d'impulsion sont déterminés pour la seizième fraction d'une période d'horloge de l'oscillateur.

5. Circuit de détection selon la revendication 4, **caractérisé en ce que** les valeurs suivantes sont utilisées :

Max = 15 15/16
Max1 = 11,5
Max2 = 11
Min2 = 3
Min1 = 2,5.

**6.** Circuit de détection selon une des revendications précédentes, **caractérisé en ce que** la sortie du détecteur de largeur d'impulsion (2) est définie sur 0, lorsqu'un défaut a été détecté ou lorsque la PLL totale est synchronisée.

**7.** Circuit de détection selon la revendication 6, **caractérisé en ce que** dans le cas où la différence par rapport au nombre entier suivant est comprise entre 3 et 11, le signal de sortie est multiplié par un facteur d'amplification (n).

**8.** Circuit de détection selon une des revendications précédentes, **caractérisé en ce que** le détecteur de largeur d'impulsion (2) est contrôlable.

**9.** Circuit de détection selon une des revendications précédentes, **caractérisé en ce qu'**après l'addition de la valeur de phase (P) et de la sortie du détecteur de largeur d'impulsion (2), ce résultat est multiplié par un facteur -1.

**10.** Procédé pour la génération d'une valeur de resyntonisation pour la fréquence d'oscillation d'une boucle à verrouillage de phase PLL, laquelle est utilisée pour la récupération d'horloge d'un flux de données, avec les étapes de procédé suivantes :

définition d'une valeur de phase (P) d'un signal du flux de données en fractions de la période d'horloge de l'oscillateur de la PLL ;
définition de la largeur d'impulsion L d'un signal du flux de données en unités de la période d'horloge de la fréquence d'oscillation de la PLL, où la largeur d'impulsion est comprise dans l'intervalle [0, ..., Max], **caractérisé en ce que** lors de la définition de la largeur d'impulsion, en fonction d'une fonction prédéfinie F(L), l'un des signaux suivants est émis :

a) la différence par rapport au nombre entier suivant de l'intervalle [0, ..., Max], où l'émission a) constitue le réglage par défaut ;
b) la différence par rapport au nombre entier suivant de l'intervalle réduit [Min2, ..., Max2], où [0 < Min1 < Min2 < ... < Max2 < Max1 < Max] s'applique, où l'émission a) constitue le réglage par défaut, où, en outre, en fonction de la fonction prédéfinie F(L) dans le cas de l'émission b), pour la différence définie dans b), soit

b1) chaque différence positive est définie sur zéro si L < Min1, soit
b2) chaque différence négative est définie sur zéro si L > Max1,

et la fonction prédéfinie F(L) exécute quatre comparaisons, pour vérifier si la largeur d'impulsion actuelle correspond à :

c1) $L \geq Max1$
c2) $L \geq Max2$
c3) $L < Min2$
c4) $L < Min1$, et

la décision b1) est choisie lorsque la largeur d'impulsion L remplit la condition c1) à un moment final prédéfini, et
la décision b2) est choisie lorsque la largeur d'impulsion L remplit la condition c4 à un moment final prédéfini ; et

lors de l'apparition de l'état b1), la décision a) est de nouveau choisie lorsque c3) est détectée une fois pour la largeur d'impulsion, et
lors de l'apparition de l'état b2), la décision a) est de nouveau choisie lorsque c2) est détectée une fois pour la largeur d'impulsion ;

addition de la valeur de phase et de la valeur de largeur d'impulsion ainsi qu'intégration de la somme de l'étape précédente pour la génération de la valeur de resyntonisation pour la boucle à verrouillage de phase.

**Fig.1**

**Fig.2**

Fig.3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4495474 A
- EP 0544358 A